# EUROPEAN PATENT APPLICATION

(11) **EP 2 876 643 A1**
(43) Date of publication of application: **27.05.2015**
(21) Application number: 14306615.7
(22) Date of filing: 13.10.2014
(51) Int. Cl.: G11C 27/02, H03M 1/12

(54) **Multi-channel synchronous sampling-and-holding circuit, multi-channel digital sampling circuit and relay protection apparatus**

(30) Priority: 22.11.2013 CN 201310597383
(71) Applicant: Schneider Electric Industries SAS, 92500 Rueil-Malmaison (FR)
(72) Inventor: Ni, Liang, 201114 Shanghai (CN)
(74) Representative: Manitz, Finsterwald & Partner GbR

(57) **Abstract**

There are provided a multi-channel synchronous sampling-and-holding circuit, a multi-channel digital sampling circuit and a relay protection apparatus. The multi-channel synchronous sampling-and-holding circuit comprises a plurality of sampling-and-holding modules, wherein the plurality of sampling-and-holding modules have a same circuit structure, and each sampling-and-holding module is configured to perform sampling and holding for a signal of one corresponding channel and comprises: a sampling sub-module configured to sample the signal of the corresponding channel; a holding sub-module configured to hold the signal collected by the sampling sub-module; and a discharging sub-module configured to discharge the holding sub-module, wherein all of the sampling sub-modules of the plurality of sampling-and-holding modules are controlled by a same sampling control signal. The multi-channel synchronous sampling-and-holding circuit ensures a synchronous sampling for a plurality of channels, and eliminates sampling timing offsets and time length offsets among the channels. The multi-channel synchronous sampling-and-holding circuit ensures an uniform processing on signals of the plurality of channels and can reduce a cost of a entire circuit.

## Description

### TECHNICAL FIELD OF THE DISCLOSURE

The present disclosure relates to a technological field of multi-channel signal acquisition, and particularly to a multi-channel synchronous sampling-and-holding circuit, a multi-channel digital sampling circuit and a relay protection apparatus.

### BACKGROUND

Currently, in implementations of the multi-channel signal acquisition, a phenomenon that the multi-channel signal acquisition is not exactly synchronized may exist. For some application areas requiring a high precision control, such inexact synchronization in multi-channel signal acquisition is not acceptable.

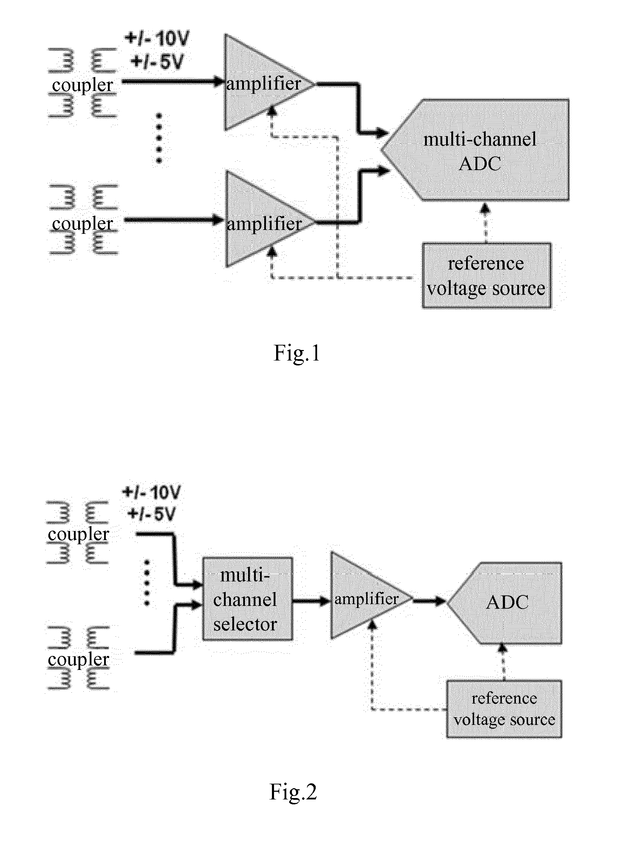

As shown in Fig. 1, which shows an existing multi-channel digital sampling circuit, multiple amplifiers and one multi-channel analog-to-digital convertor (ADC) are used, and a signal processing of each channel is relatively independent. Therefore, such multi-channel digital sampling circuit is expensive. If a separate single-channel amplifier and a separate single-channel ADC are used to perform the signal processing of each channle, such a multi-channel digital sampling circuit not only has a complicated structure, but also may have offsets in channel precisions among the respective channels due to gain errors of the respective amplifiers and conversion errors of the respective ADCs.

As shown in Fig. 2, which shows another existing multi-channel digital sampling circuit, in which a multi-channel selector, one single-channel amplifier and one single-channel ADC are used, one of multiple-channel analog signals is selected by the multi-channel selector, and then is subject to signal processing through the single-channel amplifier and the single-channel ADC. The signals of the multiple channels are selected by the multi-channel selector sequentially and then are subject to the signal processing through the single-channel amplifier and the single-channel ADC. Therefore, taking a case wherein there are N channels and a processing time for each channel is t as an example, there can be a time offset of (N-1)t between the first channel and the Nth channel, and accordingly a sampling time offset between the obtained digital signals is also (N-1)t. For example, for an exemplary application of a three-phase voltage sampling, a sum of a signal sampling time, a signal amplification time and a digital conversion time for each phase may reach tens of microseconds or even more. Therefore, there may be a time offset of tens of microseconds or even more between the digital sampling signal of the first phase and the digital sampling signal of the third phase. Such time offset is unacceptable for many application scenarios requiring the high precession control. Although the time offset among channels can be compensated by means of a software correction in later phase, such software correction in later phase also costs a correction processing time, which is equivalent to that the digital sampling signals of the respective channels are further delayed by the corresponding correction processing time, and this is more intolerable for application scenarios requiring a high response speed and a high precession control.

Therefore, a multi-channel digital sampling circuit is needed, which not only can ensure that the sampling timings for the respective channels are synchronized and the signal processing precisions for is the respective channel are the same, but also has a high response speed.

### SUMMARY

In order to solve the above technical problems, the present disclosure provides a multi-channel synchronous sampling-and-holding circuit and a multi-channel digital sampling circuit, which can, by controlling the multiple channels to perform sampling and holding synchronously and then reading and processing the hold input signals of the respective channels one by one sequentially with a same processing circuit, ensure synchronous samplings for the multiple channels, eliminate sampling timing and time length offsets among the channels, and in turn can ensure an uniform processing on the multiple channels and reduce an entire circuit cost.

According to one aspect of the present disclosure, there is provided a multi-channel synchronous sampling-and-holding circuit comprising a plurality of sampling-and-holding modules, wherein the plurality of sampling-and-holding modules have a same circuit structure, and each sampling-and-holding module is configured to perform sampling and holding on a signal of one corresponding channel and comprises: a sampling sub-module configured to sample the signal of the corresponding channel; a holding sub-module configured to hold the signal collected by the sampling sub-module; and a discharging sub-module configured to discharge the holding sub-module, wherein all of the sampling sub-modules of the plurality of sampling-and-holding modules are controlled by a same sampling control signal such that all of the sampling sub-modules of the plurality of sampling-and-holding modules perform signal sampling synchronously.

In one example, the sampling sub-module comprises a first switch and a first resistor connected in series, wherein the sampling control signal controls all of the first switches in the plurality of sampling-and-holding circuit to be turned on or turned off simultaneously.

In one example, the holding sub-module comprises a first capacitor, wherein, when the sampling sub-module samples a signal and the holding sub-module is charged, the first switch is turned on, the first resistor and the first capacitor is connected in series, and the signal of the corresponding channel charges the first capacitor through the first resistor until the charging of the first capacitor is completed.

In one example, the discharging sub-module comprises a second switch and a second resistor connected in series, wherein, when the discharging sub-module discharges the holding sub-module, the second switch is turned on, the second resistor and the first capacitor are connected in series to discharge the first capacitor until the discharging of the first capacitor is completed.

In one example, the multi-channel synchronous sampling-and-holding circuit further comprises: a multi-channel selector with a plurality of input terminals and one output terminal, which comprises a multi-channel selection switch, wherein the plurality of input terminals are connected to output terminals of the plurality of sampling-and-holding modules respectively, and the multi-channel selection switch is configured to select one of the input terminals and transfer the signal received from the selected input terminal to its output terminal.

According to another aspect of the present disclosure, there is provided a multi-channel digital sampling circuit comprising the multi-channel synchronous sampling-and-holding circuit as described above and an analog-to-digital convertor (ADC), wherein input terminals of the plurality of sampling-and-holding modules of the multi-channel synchronous sampling-and-holding circuit are connected to a plurality of channels to be sampled respectively to receive signals of the respective channels to be sampled, and the ADC receives an analog signal output from the multi-channel synchronous sampling-and-holding circuit and converts the received analog signal into a digital signal.

In one example, the multi-channel synchronous sampling-and-holding circuit further comprises: an output capacitor, a first terminal thereof is connected to the output terminal of the multi-channel selector and a second terminal thereof is grounded; and an output discharging module comprising an output discharge switch and a discharge resistor, an first terminal of the output discharging module is connected to a first terminal of the output capacitor, and a second terminal of the output discharging module is grounded, wherein the multi-channel selector further comprises a plurality of third resistors, the plurality of input terminals of the multi-channel selector are connected to first terminals of the plurality of third resistors, second terminals of the plurality of third resistors are connected to the plurality of input terminals of the multi-channel selection switch respectively, the output terminal of the multi-channel selection switch operates as the output terminal of the multi-channel selector.

In one example, the multi-channel synchronous sampling-and-holding circuit operates according to the following procedure: the sampling control signal controls all of the first switches in the plurality of sampling-and-holding modules to be turned on synchronously to charge all of the first capacitors in the plurality of sampling-and-holding modules synchronously until the chargings are completed, and then the sampling control signal controls all of the first switches in the plurality of sampling-and-holding modules to be turned off synchronously; after all of the first switches are turned off synchronously, the multi-channel selection switch selects one of the plurality of input terminals to charge the output capacitor until the charging is completed, the ADC performs an analog-to-digital conversion on the analog signal collected from the output capacitor, and after the ADC completes the analog-to-digital conversion, the output discharge switch is controlled to be turned on to discharge the output capacitor until the discharging is completed; after the discharging of the output capacitor is completed, the multi-channel selection switch selects another input terminal among the plurality of input terminals to charge the output capacitor until the charging is completed, the ADC performs the analog-to-digital conversion on the analog signal collected from the output capacitor, and the output discharge switch is controlled to be turned on to discharge the output capacitor until the discharging is completed, the operations are repeated until the multi-channel selection switch has selected all input terminals; and the discharge control signal controls all of the second switches in the multiple sampling-and-holding modules to be turned on synchronously to discharge all of the first capacitors in the plurality of sampling-and-holding modules until the dischargings are completed, and the discharge control signal controls all of the second switches in the plurality of sampling-and-holding modules to be turned off.

According to yet another aspect of the present disclosure, there is provided a relay protection apparatus comprising the multi-channel digital sampling circuit as described above.

The multi-channel synchronous sampling-and-holding circuit and the multi-channel digital sampling circuit according to embodiments of the present disclosure turn on the first switches in the plurality of channels simultaneously so as to charge the first capacitors in the plurality of channels respectively and synchronously, such that the signals of the plurality of channels are hold in the respective first capacitors, and then the signals of the multiple channels, which have been hold in the first capacitors, are selected one by one sequentially by the multi-channel selection switch, and are subject to the analog-to-digital conversion through the same ADC, so that it can ensure the synchronous sampling for the plurality of channels and the uniform processing on the plurality of channels. On the other hand, because the signals of plurality of channels are subject to the analog-to-digital conversion through the same ADC one by one sequentially, the cost of the entire circuit is reduced while the uniform processing on the plurality of channels is ensured.

Additional features and/or advantage of the present disclosure will be set forth in part in the description which follows and, in part, will be apparent from the description, or may be learned by practice of the invention. Other Objects and advantages of the present disclosure can be realized and obtained by structures specifically specified in the specification, claims and figures.

### BRIEF DESCRIPTION OF THE DRAWINGS

Drawings, which constitute a part of the specification, are provided to assist the understanding of the present disclosure and explain the present disclosure together with embodiments of the present disclosure, but not limit the present disclosure, in which:
Fig. 1 illustrates a schematic block diagram of a multi-channel digital sampling circuit in the prior art;
Fig. 2 illustrates a schematic block diagram of another multi-channel digital sampling circuit in the prior art;
Fig. 3 illustrates a schematic block diagram of a multi-channel synchronous sampling-and-holding circuit according to a first embodiment of the present disclosure;
Fig. 4 illustrates a schematic block diagram of each sampling-and-holding module according to the first embodiment of the present disclosure;
Fig. 5 illustrates a schematic circuit diagram of each sampling-and-holding module according the first embodiment of the present disclosure;
Fig. 6 illustrates a schematic circuit diagram of the multi-channel synchronous sampling-and-holding circuit according to the first embodiment of the present disclosure;
Fig. 7A illustrates a schematic block diagram of a multi-channel synchronous sampling-and-holding circuit according to a second embodiment of the present disclosure;
Fig. 7B illustrates another schematic block diagram of a multi-channel synchronous sampling-and-holding circuit according to the second embodiment of the present disclosure;
Fig. 8A illustrates a schematic circuit diagram of a multi-channel selector according to the second embodiment of the present disclosure;
Fig. 8B illustrates another schematic circuit diagram of the multi-channel selector according to the second embodiment of the present disclosure;
Fig. 9A illustrates a schematic circuit diagram of the multi-channel synchronous sampling-and-holding circuit according to the second embodiment of the present disclosure;
Fig. 9B illustrates another schematic circuit diagram of the multi-channel synchronous sampling-and-holding circuit according to the second embodiment of the present disclosure;
Fig. 10A illustrates a schematic block diagram of a multi-channel digital sampling circuit according to a third embodiment of the present disclosure;
Fig. 10B illustrates another schematic block diagram of a multi-channel digital sampling circuit according to the third embodiment of the present disclosure;
Fig. 11 illustrates a schematic circuit diagram of the multi-channel digital sampling circuit according to the third embodiment of the present disclosure; and
Fig. 12 illustrates an operation timing diagram of the multi-channel digital sampling circuit according to the third embodiment of the present disclosure.

### DETAILED DESCRIPTION

Various embodiments of the present disclosure will be described in detail with reference to the figures. Here, it should be noted that in the figures, same reference symbols are assigned to components with substantially same or similar structures or functions, and they would not be repeatedly described.

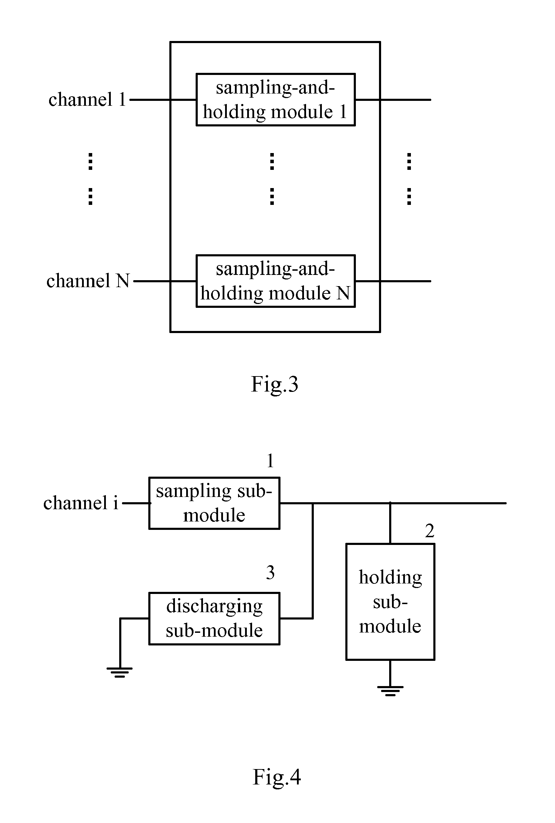

Thereafter, a multi-channel synchronous sampling-and-holding circuit according to a first embodiment of the present disclosure will be described in detail with reference to Fig. 3 to Fig. 6, which can sample and hold signals in a plurality of channels synchronously.

Fig. 3 illustrates a schematic block diagram of a multi-channel synchronous sampling-and-holding circuit according to the first embodiment of the present disclosure.

As shown in Fig. 3, the multi-channel synchronous sampling-and-holding circuit according to the first embodiment of the present disclosure comprises a plurality of sampling-and-holding modules, for example, N sampling-and-holding modules, i.e., the sampling-and-holding module 1 to the sampling-and-holding module N, where N is a positive integer larger than 2. Each sampling-and-holding module has the same circuit structure, and each sampling-and-holding module is configured to perform the sampling and holding on a signal of one corresponding channel. In particular, the sampling-and-holding module 1 is configured to perform the sampling and holding on the signal of channel 1, the sampling-and-holding module i is configured to perform the sampling and holding on the signal of channel i, and the sampling-and-holding module N is configured to perform the sampling and holding on the signal of channel N, where 1≤i≤N.

Fig. 4 illustrates a schematic block diagram of each sampling-and-holding module according to the first embodiment of the present disclosure.

Each sampling-and-holding module comprises a sampling sub-module 1, a holding sub-module 2 and a discharging sub-module 3. The sampling sub-module 1 is configured to sample the signal of the corresponding channel, the holding sub-module 2 is configured to hold the signal collected by the sampling sub-module 1, and the discharging sub-module 3 is configured to discharge the holding sub-module 2.

As shown in Fig. 4, a first terminal of the sampling sub-module 1 operates as an input terminal of the sampling-and-holding module, and receives the signal of the corresponding channel; a second terminal of the sampling sub-module 1 is connected to a first terminal of the holding sub-module 2, and charges the holding sub-module 2; a first terminal of the discharging sub-module 3 is connected to the first terminal of the holding sub-module 2 , and discharges the holding sub-module 2; and the first terminal of the holding sub-module 2 operates as an output terminal of the sampling-and-holding module, and a second terminal of the holding sub-module 2 and a second terminal of the discharging sub-module 3 are grounded.

According to the embodiment, in order to ensure a synchronous sampling for the plurality of channels, all of the sampling sub-modules 1 of the plurality of sampling-and-holding modules are controlled by a same sampling control signal such that all of the sampling sub-modules 1 of the plurality of sampling-and-holding modules perform signal samplings synchronously.

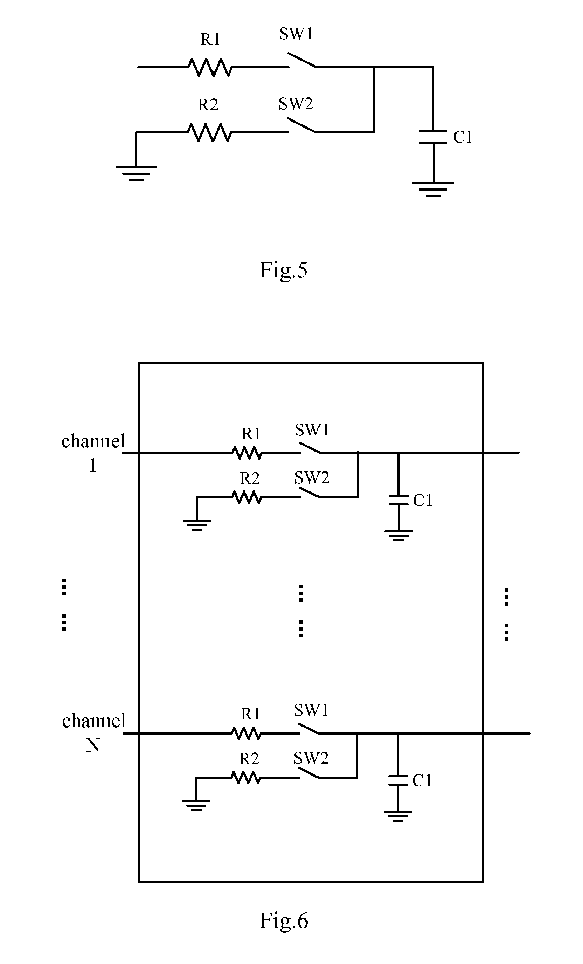

Fig. 5 illustrates a schematic circuit diagram of each sampling-and-holding module according the first embodiment of the present disclosure.

As shown in Fig. 5, the sampling sub-module 1 may comprise a first switch SW1 and a first resistor R1 connected in series. In the following description, the description is made by taking a case wherein a second terminal of the first resistor R1 is connected to a first terminal of the first switch SW1 as an example.

Although Fig. 5 shows that a first terminal of the first resistor R1 operates as an input terminal (i.e., the first terminal) of the sampling sub-module 1 and a second terminal of the first switch SW1 operates as an output terminal of the sampling sub-module 1 (i.e., the second terminal), the present disclosure is not limited thereto. The second terminal of the first switch SW1 may operate as the input terminal (i.e., the first terminal) of the sampling sub-module 1 and receives the signal of corresponding channel, and the first terminal of the first resistor R1 may operate as the output terminal (i.e., the second terminal) of the sampling sub-module 1 and be connected to an input terminal (i.e. the first terminal) of the holding sub-module 2.

Although Fig. 5 shows that the sampling sub-module 1 comprises the first switch SW1 and the first resistor R1 connected in series, the present disclosure is not limited thereto. The sampling sub-module 1 may further comprise any other suitable structure(s).

As shown in Fig. 5, the discharging sub-module 3 may comprise a second switch SW2 and a second resistor R2 connected in series. In the following description, the description is made by taking a case wherein a second terminal of the second resistor R2 is connected to a first terminal of the second switch SW2 as an example.

Although Fig. 5 shows that a first terminal of the second resistor R2 operates as the second terminal of the discharging sub-module 3 and a second terminal of the second switch SW2 operates as the first terminal of the discharging sub-module 3, the present disclosure is not limited thereto. The second terminal of the second switch SW2 may operate as the second terminal of the discharging sub-module 3 and be grounded, and the first terminal of the second resistor R2 may operate as the first terminal of the discharging sub-module 3 and be connected to the first terminal of the holding sub-module 2.

Although Fig. 5 shows that the discharging sub-module 3 comprises the second switch SW2 and the second resistor R2 connected in series, the present disclosure is not limited thereto. The discharging sub-module 3 may further comprise any other suitable structure(s).

As shown in Fig. 5, the holding sub-module 2 may comprise a first capacitor C1, a first terminal thereof is connected to the second terminal of the sampling sub-module 1 and the first terminal of the discharging sub-module 3, and operates as the output terminal of the respective sampling-and-holding module at the same time.

As described above, in order to ensure the synchronous sampling for the plurality of channels, all of the first switches SW1 in all sampling sub-modules 1 of the plurality of sampling-and-holding circuit are controlled by the same sampling control signal such that all of the first switches SW1 are turned on or turned off simultaneously.

For each sampling sub-module 1, when the sampling control signal controls the first switch to be turned on, the first resistor R1 and the first capacitor C1 is connected in series, and the signal of the corresponding channel charges the first capacitor C1 through the first resistor R1. Further, the sampling control signal controls the first switch SW1 to be kept as being turned on until the charging of the first capacitor C1 is completed. In particular, a turning-on time of the first switch SW1, i.e. an active level time of the sampling control signal, may depend on specific values of the first resistor R1 and the first capacitor C1 constituting a charging loop.

Discharge timings of the discharging sub-modules 3 in the respective sampling-and-holding modules may be different or same. That is, the discharge time of the discharging sub-module 3 in each sampling-and-holding module may be controlled separately, or all of the discharging sub-modules 3 of the plurality of sampling-and-holding modules may be controlled to be turned on or turned off by a same discharge control signal collectively such that all of the discharging sub-modules 3 of the plurality of sampling-and-holding modules discharge synchronously.

For each discharging sub-module 3, when the discharge control signal controls the second switch SW2 to be turned on, the second resistor R2 and the first capacitor C1 are connected in series, and the first capacitor C1 is discharged through the second resistor R2. Also, the discharge control signal controls the second switch SW2 to be turned on until the discharging of the first capacitor C1 is completed. In particular, a turning-on time of the second switch SW2, i.e. an active level time of the discharge control signal, may depend on specific values of the second resistor R2 and the second capacitor C3 constituting a discharging loop.

In order to further ensure the synchronous sampling for the plurality of channels, preferably, all of the first resistors in the plurality of sampling-and-holding modules have a first resistance, all of the first switches in the plurality of sampling-and-holding modules have a same model, all of the second resistors in the plurality of sampling-and-holding modules have a second resistance, all of the second switches in the plurality of sampling-and-holding modules have a same model, and all of the first capacitors in the plurality of sampling-and-holding modules have a first capacitance. In addition, the first resistance and the second resistance may be same or different, and the model of the first switch and the model of the second switch may be same or different.

Fig. 6 illustrates a schematic circuit diagram of the multi-channel synchronous sampling-and-holding circuit according to the first embodiment of the present disclosure. Connection manners and functionalities of respective circuit elements may be referred to the above description of the connection manners and functionalities of the respective circuit elements in connection with Fig. 5, which will not be described repeatedly herein.

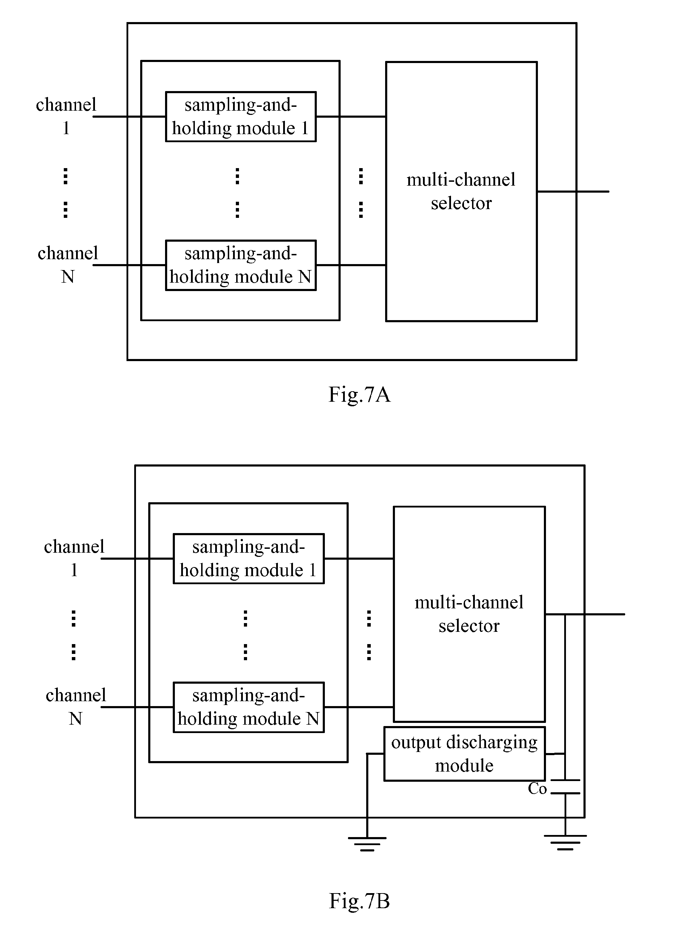

Thereafter, a multi-channel synchronous sampling-and-holding circuit according to a second embodiment of the present disclosure will be described with reference to Fig. 7 to Fig. 9, which can perform the signal sampling and holding in the plurality of channels synchronously.

Fig. 7A illustrates a schematic block diagram of the multi-channel synchronous sampling-and-holding circuit according to the second embodiment of the present disclosure.

As shown in Fig. 7A, based on the multi-channel synchronous sampling-and-holding circuit according to the first embodiment of the present disclosure, in addition to the plurality of sampling-and-holding modules, the multi-channel synchronous sampling-and-holding circuit according to the second embodiment of the present disclosure further comprises a multi-channel selector with a plurality of input terminals and one output terminal. The multi-channel selector is configured to select one of the input terminals, and transfer the signal received from the selected input terminal to its output terminal.

The specific structures and functionalities of the plurality of sampling-and-holding modules may be referred to the detailed description of the first embodiment of the present disclosure, which will not be described again herein.

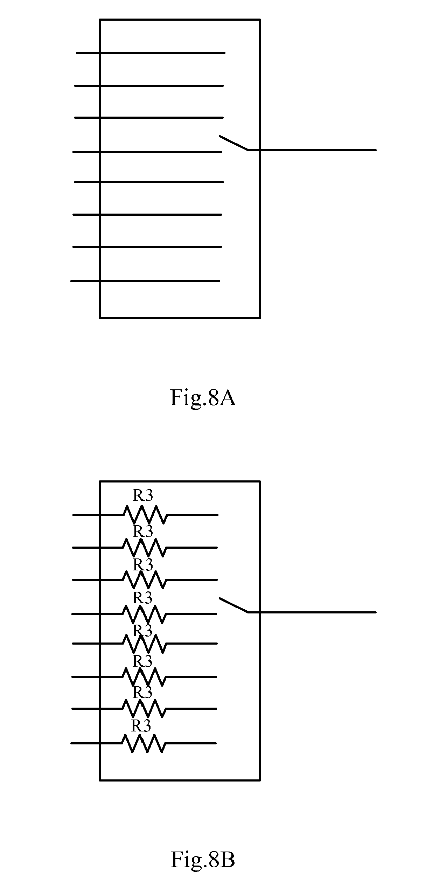

Fig. 8A illustrates a schematic circuit diagram of the multi-channel selector according to the second embodiment of the present disclosure. As shown in Fig. 8A, the multi-channel selector may comprise a multi-channel selection switch, a plurality of input terminals of the multi-channel selection switch may operate as the plurality of input terminals of the multi-channel selector respectively so as to be connected to the output terminals of the plurality of sampling-and-holding modules respectively, and the output terminal of the multi-channel selection switch may operate as the output terminal of the multi-channel selector. The multi-channel selection switch is configured to select one of the plurality of input terminals, and transfer the signal received from the selected input terminal to its output terminal.

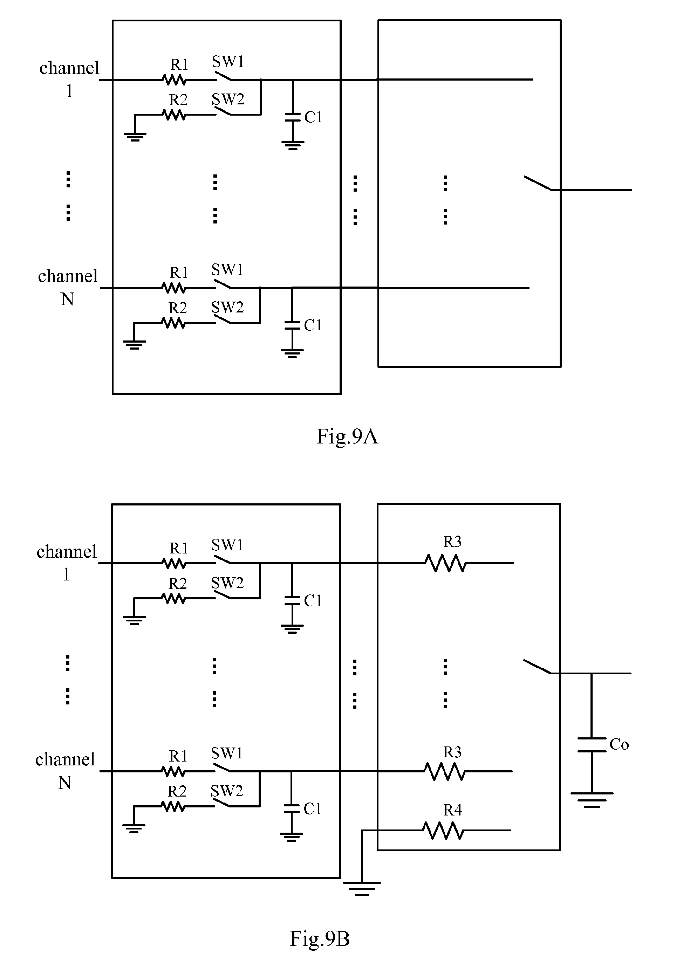

Fig. 9A illustrates a schematic circuit diagram of the multi-channel synchronous sampling-and-holding circuit according to the second embodiment of the present disclosure, in which the multi-channel selector is the multi-channel selector as shown in Fig. 8A.

Fig. 7B illustrates another schematic block diagram of the multi-channel synchronous sampling-and-holding circuit according to the second embodiment of the present disclosure.

As shown in Fig. 7B, based on the multi-channel synchronous sampling-and-holding circuit shown in Fig. 7A, the multi-channel synchronous sampling-and-holding circuit further comprises: an output capacitor Co, a first terminal thereof is connected to the output terminal of the multi-channel selector and a second terminal thereof is grounded; and an output discharging module comprising an output discharge switch and a discharge resistor R4, a first terminal of the output discharging module is connected to the first terminal of the output capacitor Co, and a second terminal of the output discharging module is grounded.

In order to charge the output capacitor Co, the multi-channel selector may further comprise a plurality of third resistors R3, wherein the plurality of input terminals of the multi-channel selector are connected to first terminals of the plurality of third resistors R3 respectively, second terminals of the plurality of third resistors R3 are connected to the plurality of input terminals of the multi-channel selection switches respectively, the output terminal of the multi-channel selection switch operates as the output terminal of the multi-channel selector, and the plurality of third resistors all have a third resistance. Fig. 8B illustrates another schematic circuit diagram of the multi-channel selector according to the second embodiment of the present disclosure.

In practical implementation, the output discharge switch may be implemented separately. Alternatively, the output discharge switch may be integrated into the multi-channel selection switch, that is, one channel of the multi-channel selection switch is selected to implement the output charge switch.

Fig. 9B illustrates another schematic circuit diagram of the multi-channel synchronous sampling-and-holding circuit according to the second embodiment of the present disclosure, in which the multi-channel selector is the multi-channel selector as shown in Fig. 8B.

In addition, in Fig. 9B, the output discharge switch is integrated into the multi-channel selection switch. Still taking the signal sampling for the N channels as an example, the multi-channel synchronous sampling-and-holding circuit according to the second embodiment of the present disclosure comprises N sampling-and-holding modules, input terminals of the N sampling-and-holing module are connected to N input terminals of the multi-channel selector respectively, and the (N+1)th input terminal of the multi-channel selector is grounded. In the multi-channel selector, the first N input terminals of the multi-channel selection switch are connected to N third resistors respectively, and the (N+1)th input terminal of the multi-channel selection switch is connected to the discharge resistor R4.

When the multi-channel selection switch selects the ith (1≤i≤N) input terminal, the corresponding third resistor R3 and the output capacitor Co are connected in series, and the signal input from the ith input terminal charges the output capacitor Co through the third resistor R3 until the charging of the output capacitor Co is completed. In particular, a strobe time during which the multi-channel selection switch selects the ith input terminal may depend on the specific values of the third resistor R3 and the output capacitor Co constituting the charging loop.

On the other hand, when the multi-channel selection switch selects the (N+1)th input terminal, the discharge resistor R4 and the output capacitor Co are connected in series, and the output capacitor Co is discharged through the discharge resistor R4 until the discharging of the output capacitor Co is completed. In particular, the discharge time of the discharge resistor R4 may depend on the specific values of the discharge resistor R4 and the output capacitor Co constituting the discharging loop.

In addition, depending on specific application requirements, the resistance of the third resistor R3 and the resistance of the discharge resistor R4 may be same or different.

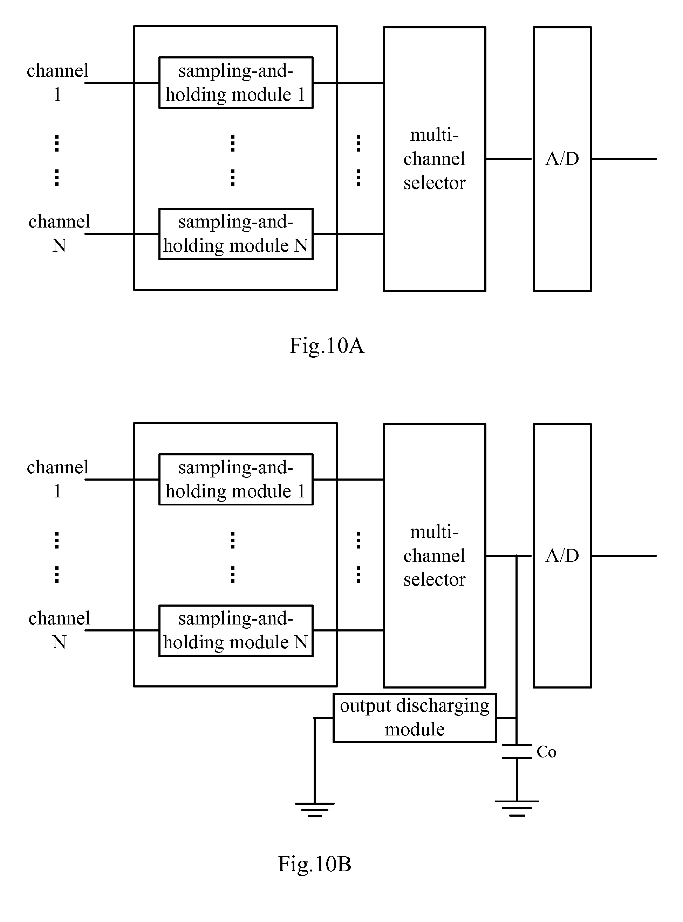

Thereafter, a multi-channel digital sampling circuit according to a third embodiment of the present disclosure will be described with reference to Fig. 10 to Fig. 12, which can not only perform the signal sampling and holding in the plurality of channels synchronously, but also perform an uniform signal processing on the signals of the plurality of channels.

Fig. 10A illustrates a schematic block diagram of a multi-channel digital sampling circuit according to a third embodiment of the present disclosure; and Fig. 10B illustrates another schematic block diagram of the multi-channel digital sampling circuit according to the third embodiment of the present disclosure.

As shown in Fig. 10A, in addition to the multi-channel synchronous sampling-and-holding circuit according to the second embodiments of the present disclosure, the multi-channel digital sampling circuit according to the third embodiment of the present disclosure further comprises an analog-to-digital converter (ADC). The multi-channel synchronous sampling-and-holding circuit according to the second embodiments of the present disclosure comprises the plurality of sampling-and-holding modules and the multi-channel selector, and may be the multi-channel synchronous sampling-and-holding circuits as shown in Fig. 7A and Fig. 9A. In particular, the ADC receives an analog signal output from the multi-channel synchronous sampling-and-holding circuit and converts the received analog signal into a digital signal.

As shown in Fig. 10B, in addition to the multi-channel synchronous sampling-and-holding circuit according to the second embodiments of the present disclosure, the multi-channel digital sampling circuit according to the third embodiment of the present disclosure further comprises an ADC. The multi-channel synchronous sampling-and-holding circuit according to the second embodiments of the present disclosure comprises the plurality of sampling-and-holding modules, the multi-channel selector, the output capacitor Co and the output discharging module, and may be the multi-channel synchronous sampling-and-holding circuits as shown in Fig. 7B and Fig. 9B. In particular, the ADC receives an analog signal output from the multi-channel synchronous sampling-and-holding circuit and converts the received analog signal into a digital signal.

In particular, as shown in Fig. 10A and Fig. 10B, the input terminals of the plurality of sampling-and-holding modules of the multi-channel digital sampling circuit are connected to the plurality of channels to be sampled respectively to receive the signals of the respective channels to be sampled. The output terminals of the plurality of sampling-and-holding modules are connected to the plurality of input terminals of the multi-channel selector, and the output terminal of the multi-channel selector is connected to the input terminal of the ADC. In addition, in Fig. 10B, the output terminal of the multi-channel selector is further connected with the output capacitor Co and the output discharging module which is configured to discharge the output capacitor Co.

In addition, according to specific application requirements, the multi-channel digital sampling circuit according to the third embodiment of the present disclosure may further comprise an amplification module (not shown), a first terminal thereof is connected to the output terminal of the multi-channel synchronous sampling-and-holding circuit and a second terminal thereof is connected to the input terminal of the ADC. The amplification module is configured to amplify the analog signal output from the multi-channel synchronous sampling-and-holding circuit, and output the amplified analog signal to the input terminal of the ADC. The amplification module may include any suitable circuit structure such as a programmable gain amplifier, an operational amplifier, and the like.

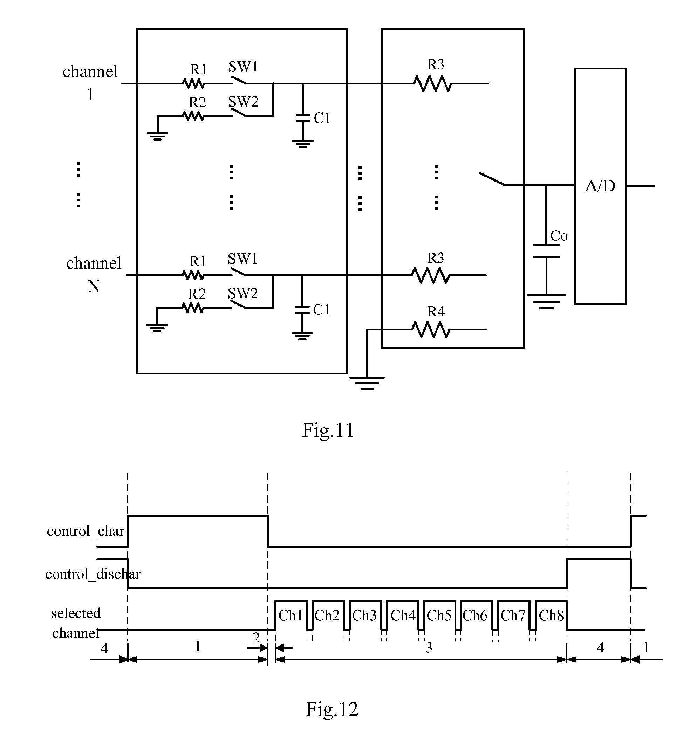

Fig. 11 illustrates a schematic circuit diagram of the multi-channel digital sampling circuit according to the third embodiment of the present disclosure, which corresponds to the block diagram shown in Fig. 10B. Connection manners and functionalities of respective circuit elements in Fig. 11 may be referred to the above description of the connection manners and functionalities of the respective circuit elements in the first embodiment and the second embodiment, which will not be described repeatedly herein.

Fig. 12 illustrates an operation timing diagram of the multi-channel digital sampling circuit according to the third embodiment of the present disclosure, which corresponds to the circuit diagram shown in Fig. 11. In the following description, it is assumed that the multi-channel digital sampling circuit has been initialized, that is, all the capacitors are discharged completely.

During a first period, the sampling control signal control_char is at a high level, the discharge control signal control_dischar is at a low level, and no channel is selected. The sampling control signal control_char controls all of the first switches SW1 in the plurality of sampling-and-holding modules to be turned on synchronously so as to charge all of the first capacitors C1 in the plurality of sampling-and-holding modules synchronously until the charging is completed.

During a second period, the sampling control signal control_char is at the low level, the discharge control signal control_dischar is still at the low level, and no channel is selected. The sampling control signal control_char controls all of the first switches SW1 in the plurality of sampling-and-holding modules to be turned off synchronously. All of the capacitors C1 in the plurality of sampling-and-holding module keep the signals.

During a third period, the sampling control signal control_char is at the low level, the discharge control signal control_dischar is still at the low level, and the plurality of channels are selected sequentially.

In particular, the multi-channel selection switch selects one of the plurality of input terminals to charge the output capacitor Co until the charging is completed, the ADC performs the analog-to-digital conversion on the analog signal collected from the output capacitor Co, and after the ADC completes the analog-to-digital conversion, the output discharge switch is controlled to be turned on so as to discharge the output capacitor Co until the discharging is completed; after the discharging of the output capacitor is completed, the multi-channel selection switch selects another input terminal among the plurality of input terminals to charge the output capacitor Co until the charging is completed, the ADC performs the analog-to-digital conversion on the analog signal collected from the output capacitor Co, and then the output discharge switch is controlled to be turned on so as to discharge the output capacitor until the discharging is completed; the above operations are repeated until the multi-channel selection switch has selected all of the input terminals.

Taking the digital sampling for 8 channels as an example, the third period may be divided into 8 sub-periods, and each sub-period may comprise a processing sub-period and a discharge sub-period.

In the processing sub-period ch1 of the first sub-period, the multi-channel selection switch selects the first input terminal (i.e., the first channel) to charge the output capacitor Co through the third resistor R3 connected to the first input terminal until the charging is completed, and then the ADC performs the analog-to-digital conversion on the analog signal collected from the output capacitor Co.

In the discharge sub-period of the first sub-period, the multi-channel selection switch selects the ninth input terminal (i.e., no channel is selected) to discharge the output capacitor Co through the discharge resistor R4 connected to the ninth input terminal until the discharging is completed.

Alternatively, if the output discharge switch is not integrated into the multi-channel selection switch, that is, if the output discharge switch is implemented separately, after the ADC completes the analog-to-digital conversion, that is, in the discharge sub-period of the first sub-period, the output discharge switch is controlled to be turned on by an output discharge signal so as to discharge the output capacitor Co until the discharging is completed.

Similarly, the following second sub-period to seven period are the same as the first sub-period except that the second input terminal and the seventh input terminal are selected respectively. In the last, eighth, sub-period, the eighth input terminal is selected, and the eighth sub-period may only comprise the processing sub-period (as shown in Fig. 12), or may comprise both the processing sub-period and the discharge sub-period (not shown, the same as the first sub-period).

During the fourth period, the sampling control signal control_char is at the low level, the discharge control signal control_dischar is still at the high level, and no channel is selected. The discharge control signal control_dischar controls all of the second switches SW2 in the plurality of sampling-and-holding modules to be turned on synchronously so as to discharge all of the first capacitors C1 in the plurality of sampling-and-holding modules until the discharging is completed.

Now, this round of sampling and holding and analog-to-digital conversion is completed.

Then, the next round of sampling and holding and analog-to-digital conversion will be started, that is, the operations of the first period, the second period, the third period and the fourth period are repeated in turn.

According to a fourth embodiment, there is also provided a relay protection apparatus comprising the multi-channel digital sampling circuit as described above.

The multi-channel synchronous sampling-and-holding circuit, the multi-channel digital sampling circuit and the relay protection apparatus according to embodiments of the present disclosure use the same sampling control signal to control the first switches in the plurality of channels to be turned on simultaneously so as to keep the signals of the plurality of channels in the respective first capacitors simultaneously and respectively, such that the plurality of channels can perform the sampling and holding synchronously, which can ensure the synchronous sampling for the plurality of channels, therefore the sampling timing offsets and sampling time length offsets among the channels are eliminated. In addition, the signals of the multiple channels, which have been hold in the first capacitors, are selected one by one sequentially by the multi-channel selection switch, and are subject to the analog-to-digital conversion through the same ADC, which can ensure the uniform processing on the plurality of channels. On the other hand, because the signals of plurality of channels are subject to the analog-to-digital conversion through the same ADC one by one sequentially, the cost of the entire circuit is reduced while the uniform processing on the plurality of channels is ensured.

Above only describes circuit components related to the concept of the present invention, and other necessary and/or optional circuit components may be added to each embodiment of the present disclosure, e.g., a coupler PT/CT, a reference power supply, and so on as shown in Fig. 1 or Fig. 2.

The above has described various embodiments in detail. However, those skilled in the art can understand that various modifications, combinations or sub-combinations can be made to these embodiments without departing from the principle and spirit of the present disclosure. These modifications should fall into the scope of the present disclosure.

## Claims

1. A multi-channel synchronous sampling-and-holding circuit comprising a plurality of sampling-and-holding modules, **characterized in that** the plurality of sampling-and-holding modules have a same circuit structure, and each sampling-and-holding module is configured to perform sampling and holding for a signal of one corresponding channel and comprises:
a sampling sub-module configured to sample the signal of the corresponding channel;
a holding sub-module configured to hold the signal collected by the sampling sub-module; and
a discharging sub-module configured to discharge the holding sub-module,
wherein all of the sampling sub-modules of the plurality of sampling-and-holding modules are controlled by a same sampling control signal such that all of the sampling sub-modules of the plurality of sampling-and-holding modules perform a signal sampling synchronously.

2. The multi-channel synchronous sampling-and-holding circuit according to claim 1, **characterized in that**, for each sampling-and-holding module,
a first terminal of the sampling sub-module operates as an input terminal of the sampling-and-holding module, and receives the signal of the corresponding channel;
a second terminal of the sampling sub-module is connected to a first terminal of the holding sub-module, and charges the holding sub-module;
a first terminal of the discharging sub-module is connected to the first terminal of the holding sub-module, and discharges the holding sub-module; and
the first terminal of the holding sub-module operates as an output terminal of the sampling-and-holding module, and a second terminal of the holding sub-module and a second terminal of the discharging sub-module are grounded.

3. The multi-channel synchronous sampling-and-holding circuit according to claim 1, **characterized in that**, for each sampling-and-holding module, the sampling sub-module comprises a first switch and a first resistor connected in series,
wherein the sampling control signal controls all of the first switches in the plurality of sampling-and-holding circuit to be turned on or turned off simultaneously.

4. The multi-channel synchronous sampling-and-holding circuit according to claim 3, **characterized in that**, for each sampling-and-holding module, the holding sub-module comprises a first capacitor,
wherein when the sampling sub-module samples a signal and charges the holding sub-module, the first switch is turned on, the first resistor and the first capacitor is connected in series, and the signal of the corresponding channel charges the first capacitor through the first resistor until the charging of the first capacitor is completed.

5. The multi-channel synchronous sampling-and-holding circuit according to claim 4, **characterized in that**, for each sampling-and-holding module, the discharging sub-module comprises a second switch and a second resistor connected in series,
wherein when the discharging sub-module discharges the holding sub-module, the second switch is turned on, the second resistor and the first capacitor are connected in series to discharge the first capacitor until the discharging of the first capacitor is completed.

6. The multi-channel synchronous sampling-and-holding circuit according to claim 5, **characterized in that** all of the discharging sub-modules of the plurality of sampling-and-holding modules are controlled by a same discharge control signal such that all of the discharging sub-modules of the plurality of sampling-and-holding modules perform the discharging synchronously.

7. The multi-channel synchronous sampling-and-holding circuit according to claim 5, **characterized in that** the first resistor in each sampling-and-holding module has a first resistance, the second resistor in each sampling-and-holding module has a second resistance, and the first capacitor in each sampling-and-holding module has a first capacitance.

8. The multi-channel synchronous sampling-and-holding circuit according to claim 5, **characterized in that** all of the first switches in the plurality of sampling-and-holding modules have a same model, and all of the second switches in the plurality of sampling-and-holding modules have a same model.

9. The multi-channel synchronous sampling-and-holding circuit according to claim 5, **characterized in that** the multi-channel synchronous sampling-and-holding circuit further comprises: a multi-channel selector with a plurality of input terminals and one output terminal, which comprises a multi-channel selection switch, wherein the plurality of input terminals are connected to the output terminals of the plurality of sampling-and-holding modules respectively,
the multi-channel selection switch is configured to select one of the input terminals, and transfer the signal received from the selected input terminal to its output terminal.

10. The multi-channel synchronous sampling-and-holding circuit according to claim 9, **characterized in that** the multi-channel synchronous sampling-and-holding circuit further comprises:
an output capacitor, a first terminal thereof is connected to the output terminal of the multi-channel selector and a second terminal thereof is grounded; and
an output discharging module comprising an output discharge switch and a discharge resistor, an first terminal of the output discharging module is connected to the first terminal of the output capacitor, and a second terminal of the output discharging module is grounded,
wherein the multi-channel selector further comprises a plurality of third resistors, the plurality of input terminals of the multi-channel selector are connected to first terminals of the plurality of third resistors, second terminals of the plurality of third resistors are connected to the plurality of input terminals of the multi-channel selection switches respectively, the output terminal of the multi-channel selection switch operates as the output terminal of the multi-channel selector, and the plurality of third resistors have a third resistance.

11. A multi-channel digital sampling circuit, **characterized in that** the multi-channel digital sampling circuit comprises the multi-channel synchronous sampling-and-holding circuit according to claim 9 or 10 and an analog-to-digital convertor (ADC),
wherein the input terminals of the plurality of sampling-and-holding modules of the multi-channel synchronous sampling-and-holding circuit are connected to a plurality of channels to be sampled respectively to receive signals of the respective channels to be sampled,
the ADC receives an analog signal output from the multi-channel synchronous sampling-and-holding circuit and converts the received analog signal into a digital signal.

12. The multi-channel digital sampling circuit according to claim 11, **characterized in that** the multi-channel digital sampling circuit further comprises an amplification module, a first terminal thereof is connected to the output terminal of the multi-channel synchronous sampling-and-holding circuit and a second terminal thereof is connected to an input terminal of the ADC,
the amplification module is configured to amplify the analog signal output from the multi-channel synchronous sampling-and-holding circuit, and output the amplified analog signal to the input terminal of the ADC.

13. The multi-channel digital sampling circuit according to claim 11, **characterized in that** the multi-channel synchronous sampling-and-holding circuit is the multi-channel synchronous sampling-and-holding circuit according to claim 10,
wherein the sampling control signal controls all of the first switches in the plurality of sampling-and-holding modules to be turned on synchronously to charge all of the first capacitors in the plurality of sampling-and-holding modules synchronously until the chargings are completed, and then the sampling control signal controls all of the first switches in the plurality of sampling-and-holding modules to be turned off synchronously;
after all of the first switches are turned off synchronously, the multi-channel selection switch selects one of the plurality of input terminals to charge the output capacitor until the charging is completed, the ADC performs an analog-to-digital conversion on the analog signal collected from the output capacitor, and after the ADC completes the analog-to-digital conversion, the output discharge switch is controlled to be turned on to discharge the output capacitor until the discharging is completed;
after the discharging of the output capacitor is completed, the multi-channel selection switch selects another input terminal among the plurality of input terminals to charge the output capacitor until the charging is completed, the ADC performs the analog-to-digital conversion on the analog signal collected from the output capacitor, and then the output discharge switch is controlled to be turned on to discharge the output capacitor until the discharging is completed, the operations are repeated until the multi-channel selection switch has selected all of the input terminals; and
the discharge control signal controls all of the second switches in the plurality of sampling-and-holding modules to be turned on to discharge all of the first capacitors in the plurality of sampling-and-holding modules until the dischargings are completed, and the discharge control signal controls all of the second switches in the plurality of sampling-and-holding modules to be turned off.

14. A relay protection apparatus, **characterized in that** the relay protection apparatus comprises the multi-channel digital sampling circuit according to any one of claims 11 to 13.
